# EUROPÄISCHE PATENTSCHRIFT

(11) **EP 2 169 695 B1**
(45) Veröffentlichungstag und Bekanntmachung des Hinweises auf die Patenterteilung: **03.01.2018**
(21) Anmeldenummer: 09170866.9
(22) Anmeldetag: 21.09.2009
(51) Int. Cl.: H01G 9/008, H01G 2/06, H01G 9/10

(54) **KONDENSATOR MIT EINEM KONDENSATORHALTER SOWIE MONTAGEANORDNUNG**
CAPACITOR WITH A CAPACITOR HOLDER AND FITTING ASSEMBLY
CONDENSATEUR DOTÉ D'UN SUPPORT DE CONDENSATEUR ET AGENCEMENT DE MONTAGE

(30) Priorität: 26.09.2008 DE 102008049189
(43) Veröffentlichungstag der Anmeldung: 31.03.2010
(73) Patentinhaber: EPCOS AG, 81669 München (DE)
(72) Erfinder: Buzetto, Fabiano, 91030-340 Porto Alegre, RS (BR); Antoniolli, Ivan, 91040-360, PORTO ALEGRE, RS (BR); Will, Norbert, 89522 Heidenheim (DE); Kasper, Eduardo, 94155-408 Gravatai Rio Grande Do Sol (RS) (BR)
(74) Vertreter: Epping - Hermann - Fischer

(56) Entgegenhaltungen:
- WO-A1-01/78474
- DE-A1-102008 049 357
- JP-A- 2000 114 119
- US-A- 2 202 166

## Beschreibung

Es wird ein Kondensator mit einem Kondensatorhalter bzw. es werden diese Gegenstände in einer Montageanordnung angegeben. Aus DE 100 17 774 B4 ist eine Befestigungsanordnung für ein Bauelement, insbesondere für einen Kondensator, bekannt. In der US 2,202,166 wird ein Kondensator gezeigt, dessen Bodenplatte durch eine Bördelung gehalten wird. In der WO 01/78474 A1 wird eine Befestigungsplatte für einen Kondensator gezeigt. In der JP 2000114119 wird ein Kondensator gezeigt, dessen Verschluss mittels einer im Gehäuse umlaufenden Sicke gehalten wird. Auch die nachveröffentlichte DE 10 2008 049 357 A1 zeigt einen Kondensator, dessen Verschluss mittels einer im Gehäuse umlaufenden Sicke gehalten wird.

Eine zu lösende Aufgabe besteht darin, einen Kondensator bzw. einen montierten Kondensator anzugeben, der möglichst lange und verlustarm bei reduzierter Schwingungsbelastung arbeitet.

So wird ein durch die Merkmale des Anspruchs 1 definierter Kondensator, insbesondere ein radialer Kondensator mit einem Montagemittel vorgeschlagen, anhand dessen der Kondensator schonend und stabil auf einer Montagefläche montiert werden kann. Beim Kondensator handelt es sich vorzugsweise um einen Elektrolytkondensator.

Der Kondensator gemäß Anspruch 1 weist ein elektrisch leitfähiges, becherförmiges Gehäuse auf, in dem ein kapazitives Element wie zum Beispiel ein Kondensatorwickel angeordnet ist. Der Kondensator ist an seiner ersten, der Öffnung des becherförmigen Gehäuses entsprechenden Stirnseite mit einem zumindest teilweise elektrisch leitfähigen und vorzugsweise lötfähigen Montagemittel mechanisch verbunden. Das Montagemittel kann als Kondensatorhalter und / oder als Stecker bezeichnet werden, da es den Kondensator hält bzw. trägt, wenn dieser auf eine Montagefläche (nachfolgend Leiterplatte genannt) montiert wird. Der Kondensatorhalter weist eine Haltefläche und ein von der Haltefläche abstehendes Befestigungsmittel auf, das mit der Leiterplatte mechanisch befestigbar ist.

In einer Montageanordnung ist das Befestigungsmittel mit der Leiterplatte befestigt, womit der Kondensator auf der Leiterplatte sicher gehalten ist. Das Befestigungsmittel kann darüber hinaus elektrisch mit einer auf der Leiterplatte verlaufenden Leiterbahn gekoppelt sein. Ist der elektrisch leitfähig ausgeführte Kondensatorhalter mit dem mit einer elektrischen Ladung beaufschlagten Kondensatorgehäuse verbunden, dient er vorteilhafterweise sowohl als erschütterungsabsorbierender Halter für den Kondensator als auch als Stromaufweitungsmittel zur Erhöhung der Niederinduktivität des montierten Kondensators bzw. der Montageanordnung.

Das vorzugsweise aluminiumhaltige bzw. aus Aluminium bestehende Kondensatorgehäuse weist eine Bördelung sowie einen Kondensatorverschluss auf, der den Innenraum des Kondensators nach außen abdichtet und ins offene Ende des Kondensatorgehäuses eingeschoben ist. Dabei schließt er den Kondensatorwickel ein und schützt es vor Kontamination. Die Haltefläche des Kondensatorhalters ist zwischen dem Kondensatorverschluss und der Bördelkante des Kondensatorgehäuses gehalten bzw. angeordnet. Das hat den Vorteil, dass der Kondensatorverschluss besser in seiner Form zwischen dem Kondensatorwickel und der Bördelung des Kondensatorgehäuses stabilisiert ist, so dass zwischen dem Kondensatorgehäuse und dem Kondensatorverschluss ein höherer Dichtdruck entsteht. Der Kondensatorhalter kann als einstückiges Einlegeblech mit zumindest einem abstehenden Bein ausgeführt sein.

Dadurch, dass die Haltefläche des Kondensatorhalters zwischen der Bördelung des Kondensatorgehäuses und dem Kondensatorverschluss gehalten ist, kann ein Überdruck im Innern des Kondensators nicht oder zumindest nur schlecht zu einer Ausbeulung der Verschlussseite, insbesondere der Bördelung des Kondensators führen. Somit kann die Dichtheit des Kondensators besser gewährleistet werden. Diese Anordnung des Kondensatorträgers hat den weiteren Vorteil, dass die Bördelkante nicht mit ihrer akuten Fläche auf die Außenseite des Kondensatorverschlusses drückt und diesen verformt. Die zur Gewährleistung der Dichtheit des Kondensators bevorzugte planare Form der Außenfläche des Kondensatorsverschlusses kann somit beibehalten werden.

Das Befestigungsmittel des Kondensatorträgers umfasst beispielsweise Mittel zum Verrasten oder zum Eingehen einer Schnappverbindung mit der Leiterplatte. Das Befestigungsmittel ist als Pin ausgeführt, der mit der Leiterplatte befestigt bzw. verschweißt, verlötet oder geklebt werden kann. Er kann einen breiteren und einem schmaleren Bereich mit oder ohne Anschlag bzw. Auflagesockel und / oder mit einem Haken ausgeführt sein.

Gemäß einer Ausführungsform ist der zumindest eine Pin des Kondensatorhalters mittels einer Schnapp-, Einpress-, Niet-, oder Klemmverbindung mit der Leiterplatte verbunden. Somit kann der Kondensator mit seinem Kondensatorhalter besonders einfach auf eine Leiterplatte montiert werden, ohne dass der Kondensatorhalter mit den zusätzlichen Arbeitsschritten Löten oder Schweißen mit der Leiterplatte verbunden werden muss. Schnapp- Klemm- Nietverbindungen reichen dabei aus, eine elektrische Kopplung zwischen dem Kondensatorhalter und der Leiterplatte zu schaffen, da bei der Verbindung zwischen dem Kondensatorhalter und der Leiterplatte zumindest eine kapazitive Ankopplung möglich ist. Ein möglicherweise vorhandener Spalt zwischen einem Pin des Kondensatorhalters und der Leiterplatte bzw. Leiterbahn könnte beispielsweise leicht von einem HF-Strom von beispielsweise größer als 1 MHz überbrückt werden.

Ungeachtet anderer Ausführungsformen kann der zumindest eine Pin des Kondensatorhalters mit der Leiterplatte verlötet werden. Somit wird eine direkte elektrische Verbindung zwischen dem Kondensatorhalter und der Leiterplatte geschaffen. Der Pin kann alternativ mit der Leiterplatte verschweißt sein.

Gemäß einer Ausführungsform weist die Leiterplatte Bohrungen auf, in die das Befestigungsmittel durchgeführt und mit diesen verankert bzw. befestigt ist.

Vorzugsweise weist die Haltefläche des Kondensatorhalters eine Aussparung auf, durch die Zuleitungen zum Kondensatorwickel des Kondensators hindurchgeführt werden können. Vorzugsweise ist der Umriss der Haltefläche des Kondensatorträgers an den inneren Umriss des Kondensatorgehäuses passungsdicht angepasst. So ist die Haltefläche gemäß einer Ausführungsform ringförmig, wobei das Kondensatorgehäuse einen zylinderförmigen Umriss aufweist.

Der Kondensatorträger ist gemäß einer Ausführungsform mit mehreren Pins ausgeführt. Diese können teilweise zur Befestigung mit der Leiterplatte eingesetzt oder als Abstandhalter ausgeführt sein, welche stets einen Abstand zwischen der untersten Kante des Kondensators (beispielsweise die Bördelung des Kondensators) und der Leiterplatte einhalten. Ein als Abstandhalter ausgeführter Pin des Kondensatorträgers setzt gemäß einer Ausführungsform mit seinem unteren Ende vorzugsweise auf die Oberfläche der Leiterplatte auf. Gemäß einer anderen Ausführungsform weist ein und derselbe Pin des Kondensatorträgers gleich zwei Funktionen auf, nämlich die eines Abstandhalters und die eines Pins zur mechanischen und gegebenenfalls elektrischen Kopplung mit der Leiterplatte auf. Dabei kann der untere Bereich des Pins schmaler ausgeführt sein, als sein oberer Bereich, sodass zwischen dem oberen und dem unterem Bereich eine Stufe bzw. ein Anschlag gebildet ist, der auf die Oberfläche der Leiterplatte stößt bzw. von dieser gehalten wird.

Es wird bevorzugt, dass der Kondensatorverschluss einen nach außen hervorstehenden Bereich aufweist, der die Leiterplatte berührt bzw. mechanisch mit dieser in Verbindung steht. Dabei kann die mechanische Verbindung des Kondensators zur Leiterplatte neben dem Kondensatorhalter zusätzlich über diesen Vorsprung des Kondensatorverschlusses erfolgen. Der Kondensatorverschluss ist elastisch und enthält ein elastisches Material, wie zum Beispiel Gummi. Das hat den Vorteil, dass Schwingungen von der Leiterplatte zumindest teilweise vom Kondensatorverschluss absorbiert bzw. gedämpft werden, bevor sie ins Innere des Kondensators gelangen. Außerdem lässt sich ein elastischer Kondensatorverschluss leichter in das Kondensatorgehäuse einführen. Der Kondensatorverschluss kann elektrisch isolierend, insbesondere als Gummistopfen ausgeführt sein. Das hat den Vorteil, dass die elektrischen Zuleitungen im Kondensatorverschluss voneinander elektrisch isoliert sind. Der Kondensatorverschluss wird von einer das Gehäuse umlaufenden, als weiteres Fixierungsmittel dienenden Sicke gehalten. Das Gehäuse ist sowohl mit einer Bördelung als auch mit einer Sicke zum sicheren Halt des Kondensatorverschlusses ausgebildet. Der Kondensatorverschluss weist vorzugsweise Durchführungslöcher zur Durchführung von elektrischen Zuleitungen zum Kondensatorwickel auf. Durch die mit dem Kondensatorhalter erreichte erhöhte Formstabilität des Kondensatorverschlusses können auch die elektrischen Zuleitungen in den Bohrungen des Kondensatorverschlusses besser gehalten werden bzw. sie können sich schlechter verschieben.

Der Kondensatorverschluss bildet mit seiner Außenseite vorzugsweise eine Stirnfläche der ersten Stirnseite des Kondensators. Es kann jedoch eine Verstärkungsplatte vorgesehen sein, die außenseitig auf dem Kondensatorverschluss angeordnet ist und den Kondensatorverschluss mechanisch verstärkt. In diesem Falle könnte die weitere Platte mit ihrer Außenseite eine Stirnfläche der ersten Stirnseite des Kondensators bilden. Die Platte weist dabei Durchführungslöcher für die elektrischen Zuleitungen zum Kondensatorwickel auf.

Gemäß einer Ausführungsform einer den Kondensator und den Kondensatorhalter umfassenden Montageanordnung sind erste und zweite Pole des Kondensatorwickels jeweils mit einer nach außen geführten elektrischen Zuleitung verbunden, wobei der erste Pol zusätzlich mit dem Kondensatorgehäuse elektrisch gekoppelt ist. Das hat den Vorteil, dass der Kondensator besonders niederinduktiv verschaltet werden kann. Das liegt daran, dass für den ersten Pol des Kondensators durch die elektrische Kopplung des ersten Pols an die erste elektrische Zuleitung sowie an das Kondensatorgehäuse ein aufgeweiteter Strompfad für einen Wechselstrom bereitgestellt ist. Insbesondere findet eine Stromaufweitung im Bereich des Kondensatorgehäuses statt. Die Stromaufweitung reduziert dabei die durch den Wechselstrom erzeugte Stärke eines Magnetfelds. Ist auch der Kondensatorhalter elektrisch mit dem Kondensatorgehäuse gekoppelt, bietet der Kondensatorhalter vorteilhafterweise eine weitere Steigerung der Niederinduktivität und der Stromaufweitung der Montageanordnung.

Es ist günstig, wenn die Strompfade von Strömen entgegensetzter Polarität parallel nebeneinander in entgegengesetzte Richtungen verlaufen. Insbesondere wird bevorzugt, dass sie bezogen auf die zentrale Längsachse des Kondensator koaxial oder zumindest im Wesentlichen koaxial verlaufen.

Beispielsweise ist ein erster Strompfad für einen Strom des ersten elektrischen Pols axial durch den Kondensatorwickel in Richtung des Bodens des Kondensatorgehäuses geführt.

Ein zweiter Strompfad für einen Strom des zweiten elektrischen Pols ist dagegen neben dem ersten Strompfad bereitgestellt und verläuft axial in eine Richtung, die von einer dem Gehäuseboden zugewandten Stirnseite des Kondensatorwickels hin zum Kondensatorhalter zeigt.

Erste und zweite Strompfade befinden sich vorzugsweise in lateraler Richtung, d.h., quer zur Längsachse des Kondensators, abwechselnd nebeneinander.

Der erste Strompfad ist vorzugsweise durch eine erste Wickelfolie des ersten Pols eines Kondensatorwickels und der zweite Strompfad durch eine zweite Wickelfolie des zweiten Pols des Kondensatorwickels gebildet. Erste und zweite Wickelfolien sind voneinander mittels eines Dielektrikums, vorzugsweise in der Form einer Oxidationsfläche der Anodenfolie einer der beiden Wickelfolien, getrennt. Durch die sich in lateraler Richtung abwechselnde Anordnung der ersten Wickelfolie, Oxidationsschicht der Isolierfolie und der zweiten Wickelfolien können bei Beaufschlagung der Kontakte bzw. der elektrischen Zuleitungen des Kondensators mit einem Wechselstrom Kapazitäten im Kondensatorwickel entstehen. Auch ist gemäß einer Ausführungsform zwischen den Wickelfolien bzw. zwischen der Oxidationsschicht einer Wickelfolie und der anderen Wickelfolie eine Abstandsfolie angeordnet, die Papier- oder Kunststoff enthält und mit einem Elektrolyten durchtränkt ist.

Das Kondensatorgehäuse bietet noch einen weiteren Strompfad für einen elektrischen Strom des ersten elektrischen Pols, welcher parallel neben dem ersten Strompfad und dem zweiten Strompfad von Boden des Gehäuses zur Haltefläche bzw. zum Kondensatorhalter verläuft. Dabei verläuft er im Wesentlichen parallel und in eine zum ersten Strompfad entgegensetzte Richtung und sowie im Wesentlichen parallel zum zweiten Strom. Durch den zusätzlichen Strompfad kann sich der Strom so aufspalten, dass die im Strompfad erzeugten Magnetfelder in ihrer Intensität schwächer werden. Da die Energie im Magnetfeld, und damit auch die Induktivität, quadratisch vom Strom abhängt, bewirkt der zusätzliche Strompfad eine Stromaufspaltung und damit eine Verringerung der magnetischen Energie, die als in der Eigeninduktivität des Kondensators gespeichert angesehen werden kann.

Eine im Wesentlichen koaxiale Anordnung von Strompfaden im Kondensator hat den Vorteil, neben der durch die Montageanordnung gebotenen Eigenschaften der Stromaufweitung eine weitere Induktivitätsreduzierung zu erreichen. Das liegt daran, dass sich die in entgegengesetzte Richtungen wirkenden Magnetfelder von in entgegengesetzten Richtungen verlaufenden Wechselströmen gegenseitig aufheben können.

Gemäß einer Ausführungsform der Montageanordnung ist ein überstehendes Ende einer Wickelfolie des Kondensatorwickels, welche den ersten elektrischen Pol trägt, mit dem Boden des Kondensatorgehäuses kontaktiert. Dabei wird bevorzugt, dass das entsprechende Ende der Folie umgebogen ist, um dabei möglichst flächig auf der Innenseite des Gehäusebodens anliegen zu können. Somit wird eine möglichst niederinduktive elektrische Verbindung zwischen der Wickelfolie und dem Kondensatorgehäuse erreicht. Das Wickelfolienende kann mit dem Boden des Kondensatorgehäuses laserverschweißt sein.

Gemäß einer Ausführungsform der Montageanordnung ist das zumindest eine mit der Leiterplatte elektrisch gekoppelte Befestigungsmittel des Kondensatorhalters so nahe wie möglich neben der elektrischen Zuleitung des zweiten elektrischen Pols angeordnet. Dabei weist der Kondensatorhalter eine Rotationsorientierung auf, durch die das Befestigungsmittel bzw. die Befestigungsmittel des Kondensatorhalters der elektrischen Zuleitung des zweiten Pols so nahe wie möglich gegenüber liegen. Eine derartige Anordnung trägt zur Niederinduktivität der Montageanordnung bei. Insbesondere wird dabei bevorzugt, dass das zumindest eine Befestigungsmittel am Rand der Haltefläche angeordnet ist. Eine mit dem Kondensatorwickel verbundene elektrische Zuleitung kann vom Kondensator axial versetzt mit der Leiterplatte elektrisch verbunden, insbesondere verlötet, sein. Somit weist die Zuleitung einen Abschnitt auf, der parallel zur Leiterplatte verläuft. Etwaige über die Zuleitung übertragene mechanische Schwingungen können somit schlechter zum Kondensator, insbesondere zur Verbindung zwischen der Zuleitung und dem Kondensatorwickel übertragen werden. Darüber hinaus ist die elektrische Zuleitung selbst weniger mechanischen Spannungen ausgesetzt, sodass der Kontakt der Zuleitung mit einer Wickelfolie des Kondensatorwickels länger bestehen bleibt bzw. schlechter unterbrochen werden kann.

Die beschriebenen Gegenstände werden anhand der folgenden Figuren und Ausführungsbeispiele näher erläutert, wobei die Figuren 5,7 und 9 keine Ausführungsformen der vorliegenden Erfindung darstellen, sondern lediglich zu deren Verständnis dienen. Dabei zeigt:
- Figur 1: einen Längsschnitt einer Anordnung mit einem Kondensator, einen Kondensatorhalter und einer Leiterplatte,
- Figur 2: einen Längsschnitt gemäß Figur 1 mit eingezeichneten elektrischen Strompfaden,
- Figur 3: eine Explosionsdarstellung des unteren Bereichs der Figur 1,
- Figur 4: eine Darstellung gemäß Figur 3 mit dem Unterschied, dass der Kondensatorhalter fehlt,
- Figuren 5 bis 8: Darstellungen verschiedener Kondensatorhalter,
- Figur 9: eine perspektivische Darstellung des unteren Bereichs eine Kondensators sowie einen diesen haltenden Kondensatorhalter.

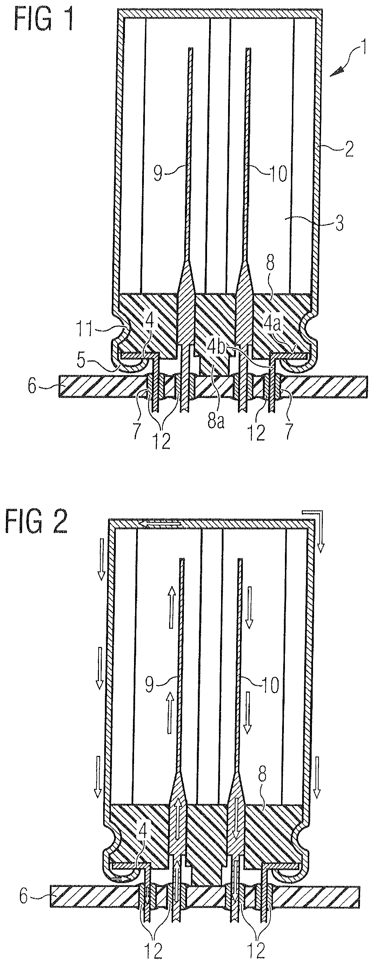

Figur 1 zeigt einen Kondensator 1, der mit seinem mit einer Bördelung 5 versehenen Ende einer Leiterplatte 6 zugewandt ist. Der Kondensator 1 weist ein Kondensatorgehäuse 2 und einen in diesem Gehäuse angeordneten Kondensatorwickel 3 auf. Der Kondensator 1 wird von einem Kondensatorhalter 4 getragen, wobei die Haltefläche 4a des Kondensatorhalters zwischen dem nach innen gebogenen Ende der Bördelung 5 bzw. dessen Kante und einem in das Kondensatorgehäuse 2 geschobenen Kondensatorverschluss 8 angeordnet ist. Beispiele von Ausführungsformen des Kondensatorhalters werden anhand nachfolgender Figuren gezeigt. In seiner Position wird der Kondensatorverschluss 8 mittels einer das Kondensatorgehäuse 2 radial umlaufenden Sicke 11 besser gehalten. Befestigungsmittel 4b des Kondensatorhalters 4 sind in Bohrungen 7 der Leiterplatte 6 eingeführt und dort festgehalten. Die Befestigungsmittel 4b des

Kondensatorhalters 4 können mit der Leiterplatte verlötet sein. Entsprechende Lötstellen in und an den Bohrungen 7 sind mit den Bezugszeichen 12 gezeigt. Die Stellen, an denen die Befestigungsmittel mit der Leiterplatte befestigt sind, können mit Leiterbahnen der Leiterplatte kontaktiert sein. Die Befestigungsmittel 4b des Kondensatorhalters sind somit mit auf bzw. in der Leiterplatte angeordneten Leiterbahnen kontaktiert. Die Leiterplatte 6 ist vorzugsweise elektrisch isolierend.

Der Kondensatorverschluss weist vorzugsweise einen nach außen hervorstehenden Bereich 8a auf. Dieser Vorsprung 8a stützt sich von der Leiterplatte 6 ab. Er ragt über die Ebene der Bördelung 5 hinaus. Die Bördelung 5 ist somit freistehend bzw. sie weist keinen mechanischen Kontakt zur Leiterplatte 6 auf. Der Kondensatorverschluss ist vorzugsweise aus Gummi oder einem anderen hart-elastischen Material hergestellt. Der Kondensatorverschluss ist elektrisch isolierend.

Elektrische Zuleitungen 9 und 10 sind durch Bohrungen des Kondensatorverschlusses 8 hindurchgeführt und kontaktierten Wickelfolien des Kondensatorwickels 3. Auf bzw. in der Leiterplatte 6 sind die elektrischen Zuleitungen mit jeweils diesen zugeordneten Leiterbahnen elektrisch kontaktiert, beispielsweise verlötet.

Vorteilhafterweise sind die elektrischen Zuleitungen bezüglich mechanischer Schwingungen entlastet, in dem der Kondensatorhalter 4 die Schwingkräfte auf den Kondensator zumindest teilweise übernimmt. Die Zuleitungen werden somit gegebenenfalls nur noch durch die geringen Relativbewegungen zwischen dem Kondensatorhalter 4 und den Zuleitungen belastet. Somit ist die sensible innere Schweißung zwischen den Zuleitungen und den Wickelfolien des Kondensatorwickels geschützter.

Auf der dem Boden des Kondensatorgehäuses 2 zugewandten Stirnseite des Kondensatorwickels 3 ist eine überstehende Kathodenfolie des Wickels umgebogen, welche flächig mit der Innenwand des Bodens des Kondensatorgehäuses kontaktiert ist. Somit ist eine elektrische Zuleitung mit dem Kondensatorgehäuse 2 elektrisch kontaktiert. Beide sind somit demselben elektrischen Pol zuzuordnen.

Zwischen der Leiterplatte 6 und dem Kondensator 1 können weitere Bauelemente angeordnet werden. Der Abstand zwischen Leiterplatte und Kondensator kann an den Erfordernissen bezüglich Unterlüftung, Reinigbarkeit und Einsehbarkeit eingestellt werden. Insbesondere lässt sich dieser Abstand in einfachster Weise durch eine geeignete Wahl der Länge des vom Kondensatorverschluss abstehenden Vorsprungs 8a einstellen.

Elektrische Zuleitungen 9 und 10 können derart umgebogen sein, dass sie jeweils einen auf der Leiterplatte 8 liegenden Abschnitt aufweisen (nicht gezeigt). Eine Zuleitung 9 bzw. 10 kann von der zentralen Längsachse des Kondensators deutlich versetzt auf der Leiterplatte bzw. in einer Bohrung der Leiterplatte eingelötet werden. Das hat den Vorteil, dass auch hochfrequente mechanische Schwingungen nicht über die Zuleitung in den Kondensator gelangen können. Dadurch wird auch eine Lötstelle der Zuleitung auf der Leiterplatte von oben zugänglich bzw. zugänglicher. Eine entsprechende Lötstelle der versetzten Zuleitung auf der Leiterplatte muss jedoch nicht in einer Bohrung angeordnet sein. Das hat den weiteren Vorteil, dass der Kondensator nicht hoch erhitzt werden muss um eine Reflow-Lötung der Kontaktierung der elektrischen Zuleitungen durchzuführen. Durch die lateral versetzte Anordnung von Lötstelle und Kondensator muss der Kondensator in einem Reflow-Ofen nicht heiß werden, bis die Lötstelle bereits ausreichend erwärmt wird, um eine elektrische Kontaktierung zur Zuleitung zu erreichen.

Die Zuleitung 9 bzw. 10 kann einen auf der Leiterplatte hochkant stehendes Ende aufweisen, das als Heizantenne wirkt. Diese als Heizantenne dienende Verlängerung der elektrischen Zuleitung beschleunigt ihre Erwärmung in einem Reflow-Ofen.

Figur 2 zeigt die elektrischen Strompfade in einer Montageanordnung eines Kondensators. Es wird gezeigt, wie dem Kondensatorwickel bzw. dessen einen Wickelfolie über die elektrische Zuleitung 9 Strom zugeführt wird. Die Pfeile in der Figur zeigen die Strömungen von in den Kondensator einfließenden und aus dem Kondensator abfließenden Wechselströmen. Vom Kondensator abfließende Wechselströme werden sowohl über eine elektrische Zuleitung 10 und über das Kondensatorgehäuse 2 als auch über dem Kondensatorhalter 4 zu einer bzw. mehreren gleichpoligen Leiterbahnen der Leiterplatte insgesamt niederinduktiv geleitet.

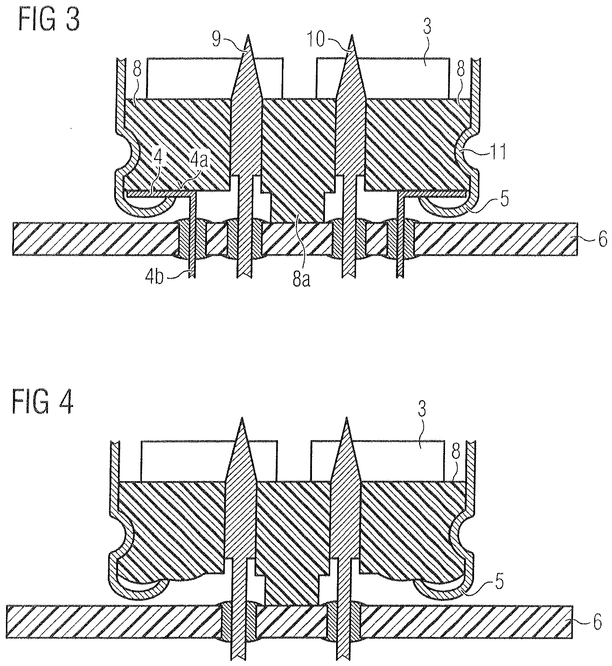

Figur 3 ist eine Explosionsdarstellung des Kopplungsbereiches des Kondensators 1 und der Leiterplatte 6. Es wird gezeigt, wie der Kondensatorhalter 4 mittels seiner planen Haltefläche 4a die der Leiterplatte zugewandte Außenfläche des Kondensatorverschlusses 8 flach hält.

Im Gegensatz zur Figur 3 zeigt Figur 4, wie mangels des Kondensatorträgers 4 die genannte Außenfläche des Kondensatorverschlusses 8 mittels der Bördelkante des Kondensatorgehäuses 2 eingedrückt wird. Die Verformung des Kondensatorverschlusses birgt die Gefahr, dass der Kondensatorverschluss den Innenraum des Kondensators nicht mehr zuverlässig nach außen abdichten kann. Außerdem könnte der Kondensatorverschluss mangels eines durch den Kondensatorträger gebildeten festen Anschlags bei einem Überdruck im Kondensatorinnenraum die Bördelung nach außen wegdrücken und dabei Gas aus dem Kondensatorinnenraum nach außen entweichen lassen.

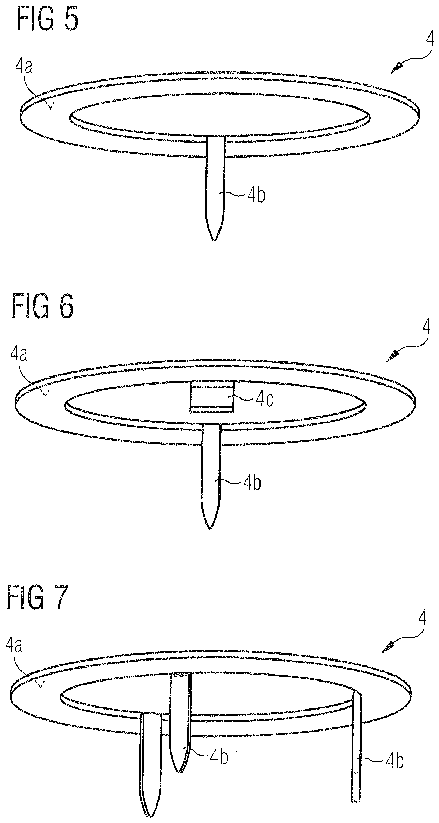

Figur 5 zeigt eine Ausführung eines Kondensatorhalters 4. Er bzw. dessen Haltefläche 4a ist ringförmig und weist ein einziges, abstehendes Befestigungsmittel 4b auf, das als Pin ausgeführt ist. Der Pin 4b kann mit einer Leiterplatte bzw. mit einer Leiterbahn einer Leiterplatte verlötet sein. Somit wird der Kondensatorhalter auch mechanisch mit der Leiterplatte verbunden. Der Pin trägt somit die gesamte Last des Kondensators. Etwaige mechanische Schwingungen können von der Leiterplatte nur noch über diesen Pin oder über diesen Pin und einem auf der Leiterplatte sitzenden Vorsprung des Kondensatorverschlusses zum Kondensator übertragen werden. Die elektrischen Zuleitungen zum Kondensatorwickel müssen keiner oder zumindest nur weniger mechanischer Belastung ausgesetzt werden.

Figur 6 zeigt eine Ausführung eines Kondensatorhalters 4 gemäß Figur 5, jedoch mit dem Unterschied, dass vom ringförmigen Haltebereich 4a des Kondensatorhalters 4 nicht nur ein Pin 4b, sondern auch ein Abstandhalter 4c absteht. Der Abstandhalter 4c setzt somit direkt auf die Oberfläche einer Leiterplatte auf und sichert einen Abstand des Kondensators zur Leiterplatte. Er verhindert, dass der Pin 4b zu weit in eine Bohrung bzw. in ein Befestigungsloch der Leiterplatte eingeführt wird.

Figur 7 zeigt eine Ausführung eines Kondensatorhalters 4 gemäß Figur 5, wobei in diesem Falle drei Pins 4b von der ringförmigen Haltefläche 4a abstehen.

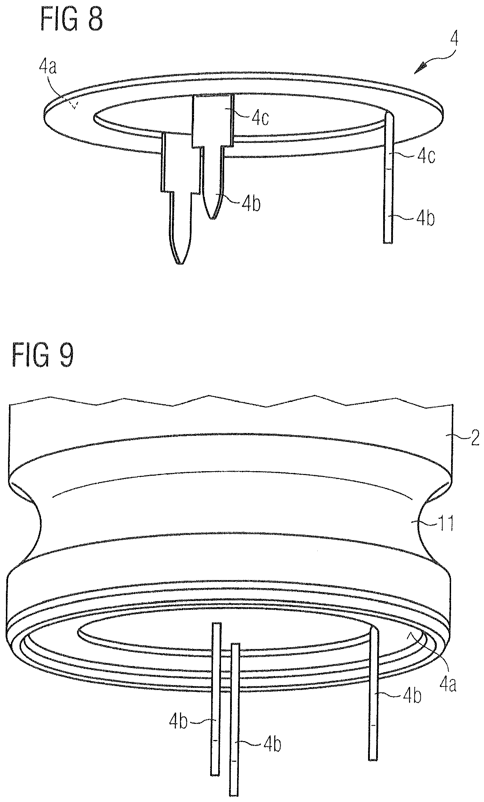

Gemäß Figur 8 können die drei Pins 4b gemäß Figur 7 mit Anschlägen bzw. Auflagesockeln versehen sein, die als Abstandhalter 4c dienen. Dabei ist jeder Pin mit zumindest einer Stufe verjüngend ausgebildet. Ein oberer Bereich eines jeden Pins ist breiter ausgeführt als ein unterer Bereich. Die Stufe zwischen diesen Bereichen kann entfallen, wenn der Pin kontinuierlich und stark verjüngend ausgebildet ist, damit er beim Einschieben in eine Bohrung bzw. in ein Befestigungsloch der Leiterplatte ab einer bestimmten Strecke stecken bleibt.

Figur 9 zeigt die Unterseite eines Kondensators, der von einem Kondensatorhalter 4 mit abstehenden Pins 4b, die mit einer Montagefläche verlötet bzw. befestigt werden können, getragen wird.

### Bezugszeichenliste

- 1: Kondensator
- 2: Kondensatorgehäuse
- 3: Kondensatorwickel
- 4: Kondensatorhalter
- 4a: Haltefläche des Kondensatorhalters
- 4b: Befestigungsmittel des Kondensatorhalters
- 5: Bördelung des Kondensatorgehäuses
- 6: Leiterplatte
- 7: Befestigungsloch der Leiterplatte
- 8: Kondensatorverschluss
- 8a: Vorsprung des Kondensatorverschlusses
- 9: erste elektrische Zuleitung des Kondensators
- 10: zweite elektrische Zuleitung des Kondensators
- 11: eine das Kondensatorgehäuse umlaufende Sicke
- 12: Lötstelle

## Patentansprüche

1. Kondensator mit einem Kondensatorhalter, wobei
- der Kondensator (1) ein elektrisch leitfähiges, becherförmiges Gehäuse (2) mit einer Bördelung (5) aufweist,
- der Kondensatorhalter (4) elektrisch leitfähig ist und eine Haltefläche (4a) sowie zumindest ein als Pin ausgeführtes Befestigungsmittel (4b) zur Befestigung mit einer Montagefläche (6) und einen von der Haltefläche (4a) abstehenden Abstandhalter (4c) aufweist, der auf die als Leiterplatte ausgeführte Montagefläche (6) aufsetzbar ist bei Einführen des Pin (4b) in eine Bohrung oder in ein Befestigungsloch der Leiterplatte (6), wobei
- ein elastischer Kondensatorverschluss (8) im Gehäuse eingesetzt ist und den Innenraum des Kondensators nach außen abdichtet, und wobei
- die Haltefläche des Kondensatorhalters (4) zwischen dem Kondensatorverschluss (8) und der Bördelkante der Bördelung (5) festgehalten ist,
**dadurch gekennzeichnet, dass**
- der Kondensatorverschluss (8) am Kondensatorhalter (4) anliegt und der Kondensatorverschluss (8) mittels einer das Gehäuse (2) umlaufenden Sicke (11) gehalten wird.

2. Kondensator nach Anspruch 1, dessen Kondensatorhalter (4) eine ringförmige Haltefläche (4a) aufweist.

3. Kondensator nach einem der vorhergehenden Ansprüche, dessen Kondensatorhalter (4) zumindest ein lötbares Befestigungsmittel (4b) aufweist.

4. Kondensator nach einem der vorhergehenden Ansprüche, bei dem ein überstehendes Ende einer Wickelfolie eines im Gehäuse angeordneten Kondensatorwickels (3) mit dem Boden des Gehäuses (2) kontaktiert ist.

5. Kondensator nach einem der vorhergehenden Ansprüche, bei dem gegenpolige elektrische Zuleitungen (9, 10) durch den Kondensatorverschluss (8) ins Innere des Kondensators geführt sind.

6. Kondensator nach einem der vorhergehenden Ansprüche, dessen Kondensatorverschluss (8) mit einem Vorsprung (8a) versehen ist, der von der Außenfläche des Kondensatorverschlusses über die Bördelung (5) hinaus absteht.

7. Montageanordnung mit einem Kondensator mit einem Kondensatorhalter nach einem der vorhergehenden Ansprüche, bei der das zumindest eine Befestigungsmittel (4b) des Kondensatorhalters (4) mit einer Leiterplatte (6) befestigt ist.

8. Montageanordnung nach Anspruch 7, bei der das zumindest eine Befestigungsmittel (4b) in einer Bohrung (7) der Leiterplatte befestigt ist.

9. Montageanordnung nach einem der Ansprüche 7 oder 8, bei der das Befestigungsmittel (4b) mit der Leiterplatte (6) verlötet ist.

10. Montageanordnung nach einem der Ansprüche 7 bis 9, bei der das zumindest eine Befestigungsmittel (4b) mit auf oder in der Leiterplatte (6) verlaufenden Leiterbahnen elektrisch gekoppelt ist.

11. Montageanordnung nach Anspruch 10, bei der das zumindest eine Befestigungsmittel (4b) von einer Leiterbahn beabstandet ist und die elektrische Kopplung über eine kapazitive Kopplung erfolgt.

12. Montageanordnung nach einem der Ansprüche 7 bis 11, bei der zumindest eine elektrische Zuleitung (9, 10) so auf der Leiterplatte (6) befestigt ist, dass die Zuleitung (9, 10) einen Abschnitt aufweist, der parallel zur Leiterplatte (6) verläuft.

## Claims

1. Capacitor with a capacitor holder, wherein
- the capacitor (1) comprises an electrically conductive, cup-like housing (2) with a beading (5),
- the capacitor holder (4) is electrically conductive and comprises a holding surface (4a) and also comprises at least one fastening means (4b), which is designed as a pin, for fastening to a mounting surface (6) and comprises a spacer (4c) which protrudes from the holding surface (4a) and can be placed onto the mounting surface (6), which is designed as a printed circuit board, when the pin (4b) is introduced into a bore or into a fastening hole in the printed circuit board (6), wherein
- an elastic capacitor closure (8) is inserted in the housing and seals off the interior of the capacitor to the outside, and wherein
- the holding surface of the capacitor holder (4) is firmly held between the capacitor closure (8) and the beading edge of the beading (5),
**characterized in that**
- the capacitor closure (8) bears against the capacitor holder (4) and the capacitor closure (8) is held by means of a bead (11) which runs around the housing (2).

2. Capacitor according to Claim 1, the capacitor holder (4) of which has an annular holding surface (4a) .

3. Capacitor according to either of the preceding claims, the capacitor holder (4) of which has at least one solderable fastening means (4b).

4. Capacitor according to one of the preceding claims, in which a protruding end of a winding foil of a capacitor winding (3) which is arranged in the housing is contact-connected to the base of the housing (2) .

5. Capacitor according to one of the preceding claims, in which electrical feed lines (9, 10) of opposing polarity are routed through the capacitor closure (8) into the interior of the capacitor.

6. Capacitor according to one of the preceding claims, the capacitor closure (8) of which is provided with a projection (8a) which protrudes beyond the beading (5) from the outer surface of the capacitor closure.

7. Mounting arrangement comprising a capacitor with a capacitor holder as claimed in one of the preceding claims, in which mounting arrangement the at least one fastening means (4b) of the capacitor holder (4) is fastened to a printed circuit board (6).

8. Mounting arrangement according to Claim 7, in which the at least one fastening means (4b) is fastened in a bore (7) in the printed circuit board.

9. Mounting arrangement according to either of Claims 7 and 8, in which the fastening means (4b) is soldered to the printed circuit board (6).

10. Mounting arrangement according to one of Claims 7 to 9, in which the at least one fastening means (4b) is electrically coupled to conductor tracks which run on or in the printed circuit board (6).

11. Mounting arrangement according to Claim 10, in which the at least one fastening means (4b) is at a distance from a conductor track and the electrical coupling is performed by means of a capacitive coupling.

12. Mounting arrangement according to one of Claims 7 to 11, in which at least one electrical feed line (9, 10) is fastened on the printed circuit board (6) in such a way that the feed line (9, 10) has a section which runs parallel to the printed circuit board (6).

## Revendications

1. Condensateur avec un support de condensateur, dans lequel
- le condensateur (1) comporte un boîtier électroconducteur en forme de godet (2) avec un sertissage (5),
- le support de condensateur (4) est électroconducteur et comporte une face de maintien (4a) telle qu'au moins un moyen de fixation réalisé comme broche (4b) opère une fixation à la surface de montage (6) et une entretoise (4c), soutenue par la surface de maintien (4a), cette entretoise étant située sur la surface de montage (6) réalisée comme circuit imprimé par insertion de la broche (4b) dans une perforation ou un trou de fixation du circuit imprimé (6)
- un disque d'isolement élastique (8) est utilisé dans le boîtier et assure l'étanchéité de l'espace interne du condensateur vis-à-vis de l'extérieur, et dans lequel,
- la face de maintien du support de condensateur (4) est maintenue entre le disque d'isolement (8) et le rebord du sertissage (5),
**caractérisé en ce que**,
- le disque d'isolement (8) est adjacent au support de condensateur (4) et le disque d'isolement est maintenu par la rainure (11) entourant le boîtier (2).

2. Condensateur selon la revendication 1, dont le support (4) comporte une surface de maintien annulaire (4a).

3. Condensateur selon une des revendications précédentes, dont le support (4) comporte au moins un moyen de fixation (4b) soudable.

4. Condensateur selon une des revendications précédentes, où une extrémité d'un noyau d'enroulement d'un bobinage (3) agencé dans le boîtier est en contact avec le fond du boîtier (2).

5. Condensateur selon une des revendications précédentes, où les deux connecteurs de polarités opposées (9, 10) pénètrent dans l'intérieur du condensateur au travers du disque d'isolement (8).

6. Condensateur selon une des revendications précédentes, dont le disque d'isolement (8) est pourvu d'une saillie (8a) partant de la surface extérieure du disque d'isolement et dépassant le sertissage (5).

7. Dispositif de montage avec un condensateur et avec un support de condensateur selon une des revendications précédentes, où au moins un moyen de fixation (4b) du support (4) est attaché à un circuit imprimé (6).

8. Dispositif de montage selon la revendication 7, où au moins un moyen de fixation (4b) est attaché à une perforation (7) du circuit imprimé.

9. Dispositif de montage selon une des revendications 7 et 8, où le moyen de fixation (4b) est soudé au circuit imprimé (6).

10. Dispositif de montage selon une des revendications 7 à 9, où au moins un moyen de fixation (4b) est électriquement couplé à une piste conductrice dans ou sur le circuit imprimé (6).

11. Dispositif de montage selon la revendication 10, où au moins un moyen de fixation (4b) est espacé par rapport à une piste conductrice et le couplage électrique se fait par le biais d'un couplage capacitif.

12. Dispositif de montage selon une des revendications 7 à 11, où au moins un connecteur (9, 10) est attaché au circuit imprimé (6) de telle sorte que le connecteur (9, 10) comporte une section qui soit parallèle au circuit imprimé (6).
